# EUROPEAN PATENT SPECIFICATION

(11) **EP 3 386 056 B1**
(45) Date of publication and mention of the grant of the patent: **14.10.2026**
(21) Application number: 18163662.2
(22) Date of filing: 23.03.2018
(51) Int. Cl.: H02H 9/02, H02H 9/04

(54) **METHOD AND DEVICE FOR ELECTRICAL OVERSTRESS AND ELECTROSTATIC DISCHARGE PROTECTION**
VERFAHREN UND VORRICHTUNG ZUM SCHUTZ VOR ELEKTRISCHER ÜBERLASTUNG UND ELEKTROSTATISCHER ENTLADUNG
PROCÉDÉ ET DISPOSITIF DE SURCHARGES ÉLECTRIQUES ET PROTECTION CONTRE LES DÉCHARGES ÉLECTROSTATIQUES

(30) Priority: 28.03.2017 US 201762477959 P; 19.03.2018 US 201815925569
(43) Date of publication of application: 10.10.2018
(73) Proprietor: Semtech Corporation, Camarillo, CA 93012 (US)
(72) Inventor: ROSE, David J., Camarillo, CA 93012 (US); RUSSELL, William A., Thousand Oaks, CA 91360 (US); CLARK, Jonathan, Camarillo, CA 93010 (US)
(74) Representative: Grünecker Patent- und Rechtsanwälte PartG mbB

(56) References cited:
- EP-A1- 0 461 054
- EP-B1- 2 182 606
- WO-A1-2006/050568
- WO-A1-95/01667
- US-A1- 2006 158 816
- US-A1- 2009 207 542
- US-A1- 2010 277 847
- US-A1- 2013 215 808
- US-B2- 6 714 393
- US-B2- 9 998 117

## Description

### Field of the Invention

The present invention relates in general to semiconductor devices and, more particularly, to a semiconductor device and method of protecting a device from electrical overstress (EOS) and electrostatic discharge (ESD) events.

### Background of the Invention

Semiconductor devices are commonly found in modern electronic products. Semiconductor devices vary in the number and density of electrical components. Discrete semiconductor devices generally contain one type of electrical component, e.g., a light emitting diode (LED), small signal transistor, resistor, capacitor, inductor, or power metal-oxide-semiconductor field-effect transistor (MOSFET). Integrated semiconductor devices typically contain hundreds to millions of electrical components. Examples of integrated semiconductor devices include microcontrollers, microprocessors, charged-coupled devices (CCDs), solar cells, and digital micro-mirror devices (DMDs).

Semiconductor devices perform a wide range of functions such as signal processing, high-speed calculations, transmitting and receiving electromagnetic signals, controlling electronic devices, transforming sunlight to electricity, and creating visual projections for television displays. Semiconductor devices are found in the fields of entertainment, communications, power conversion, networks, computers, and consumer products. Semiconductor devices are also found in military applications, aviation, automotive, industrial controllers, and office equipment.

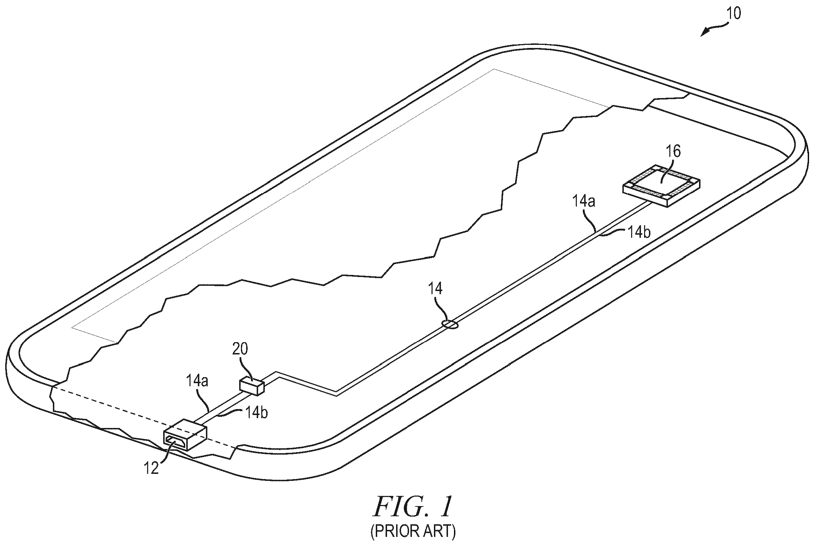

Transient-voltage-suppression (TVS) diodes are commonly used to protect semiconductor devices from electrostatic discharge (ESD). A TVS diode can be coupled in parallel with a load to shunt transient voltage spikes away from the load, typically to ground. FIG. 1 illustrates one example with regard to a mobile device 10 having a Universal Serial Bus (USB) port 12. A data line 14a and ground line 14b are routed on a printed circuit board (PCB) from USB port 12 to a microprocessor (CPU), USB controller, or other semiconductor device 16. Data line 14a allows high-speed transfer of data between CPU 16 and an external device connected to USB port 12. A ground line 14b is routed from USB port 12 to CPU 16 so that the external device and mobile device 10 are operating on the same ground voltage potential.

TVS diode 20 is coupled from data line 14a to ground line 14b to protect CPU 16 from electrical overstress (EOS) and ESD events on data line 14a. TVS diode 20 is approximately an open circuit at normal voltage levels for data line 14a. However, the resistance of electrical current through TVS diode 20 is substantially reduced when the voltage potential of data line 14a increases over a breakdown voltage of the TVS diode. Excess electrical current from ESD or EOS events on data line 14a flows through TVS diode 20 to ground line 14b, which helps keep the voltage potential at data line 14a within safe levels for the interconnect terminal of CPU 16.

One problem with TVS diodes for ESD and EOS suppression is that TVS diodes have a junction capacitance that is proportional to the current handling capability of the TVS diode. When used to protect high-speed data lines, a low capacitance is generally desired to reduce adverse effects of the junction capacitance on signal integrity. One method of reducing apparent capacitance of the TVS device is to integrate steering diodes in a bridge configuration. A TVS device including steering diodes has a reduced capacitance, allowing the TVS device to be better suited for high frequency data lines, but then the TVS device is of limited use for EOS protection due to lower current handling capability. Low capacitance to ground and high current surge capability remain difficult to achieve together.
US 2010/277847 A1 discloses a protection device for a unidirectional device capable of preventing a surge current that exceeds a preset trip value between source and load terminals in response to a voltage surge. A protection device is connected in series between a source or voltage supply across the source and load terminals. The protection device includes a DCB, a first ECB, a second ECB, and a CLL. The entire voltage drop across the bidirectional protection device is applied to the gate of the first ECB to reduce its ON resistance when current flows from one terminal to another terminal. Similarly, when current flows from one terminal to another terminal, the entire voltage drop across the bidirectional protection device is applied to the gate of first ECB a to reduce its ON resistance.
US 2009/0207542 A1 discloses a voltage surge protection device comprising at least one input designed to be connected to an electric power supply system, at least one output designed to be connected to an electric circuit to be protected, and voltage surge limiting means connected between the inputs and outputs to protect the electric circuit. The voltage surge limiting means comprises bidirectional series electronic limiting means comprising at least two inputs/outputs connected in series with at least one of the inputs and which are turned on when a low voltage drop occurs.
WO 2006/050568 A1 discloses a voltage triggered protective circuit comprising a diac in series with a bidirectional zener diode connected between the output side of a transistorized surge protection device and a surge sinking node.
WO 95/01667 discloses a device including a p-channel FET and an n-channel FET connected with their conductive channels in series and the gate of each transistor coupled to the drain terminal of the other.
EP 0 461 054 A1 discloses a circuit in which the gate of a transistor is coupled to the load, but not directly.

### Summary

It is therefore the object of the present invention to provide an improved semiconductor device in which the load is electrically coupled to a signal source through a transistor, as well as a corresponding method of making a semiconductor device.
This object is solved by the subject matter of the independent claims. A preferred embodiment is defined by the dependent claim.

### Brief Description of the Drawings

FIG. 1 illustrates using a TVS diode as a parallel protection circuit;
FIGs. 2a-2c illustrate a series protection circuit used in combination with the TVS diode;
FIG. 3 illustrates an implementation of the series protection circuit as a voltage blocking circuit;
FIGs. 4a and 4b illustrate the series protection circuit as bidirectional voltage blocking circuits;
FIG. 5 illustrates an implementation of the series protection circuit as a current blocking circuit according to an embodiment of the invention as defined by the claims;
FIGs. 6a and 6b illustrate the series protection circuit and TVS diode used in combination to protect a high speed data line; and
FIGs. 7a and 7b illustrate the series protection circuit and TVS diode in a monolithic package.

### Detailed Description of the Drawings

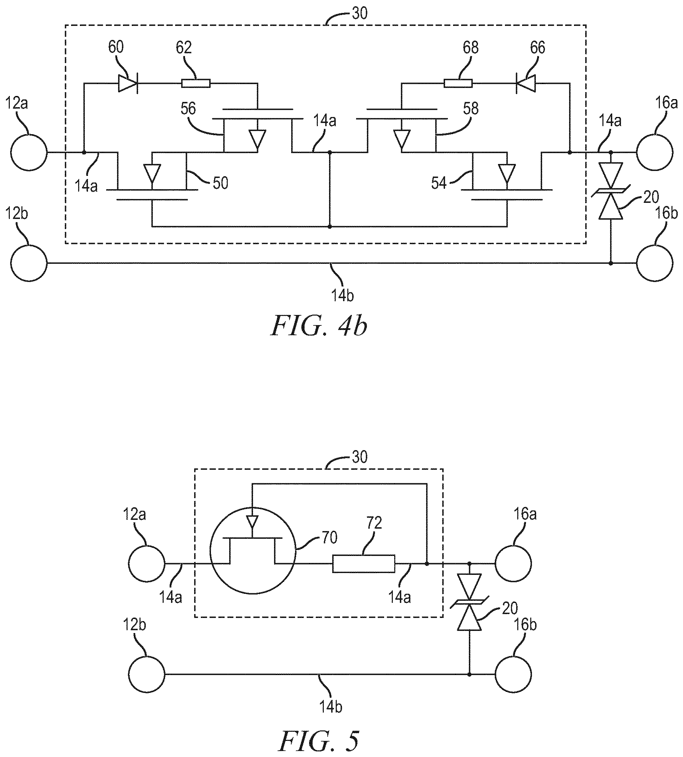

In the following description with reference to the figures, like numerals represent the same or similar elements. While the following description provides examples with reference to the drawings in terms of the best mode for achieving the invention's objectives, the invention is only defined by the appended claims and as supported by Figure 5.

While the invention is described in terms of a USB port on a mobile device, the described electrical over-stress (EOS) and electrostatic discharge (ESD) protection method and device is usable with any suitable data line, e.g., Ethernet, HDMI, DVI, SATA, etc. The described EOS and ESD protection is also useable with power lines, analog audio lines, radio frequency (RF) lines, and any other conductor that transmits an electrical signal. The device could be a cell phone as illustrated, any other device with a USB or other data port, an expansion card for insertion into a personal computer, a dedicated media player, or any other electronic device.

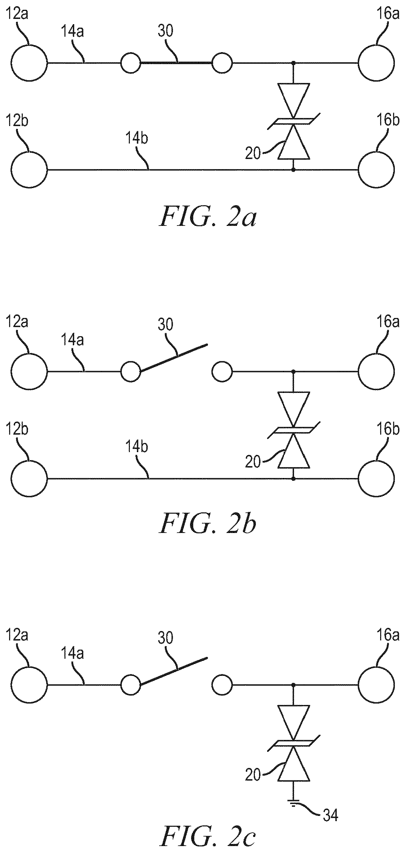

FIGs. 2a-2c illustrate utilizing a series protection circuit 30 in combination with TVS diode 20, which is used as a parallel protection circuit. Interconnect terminals 12a and 12b represent physical conductors of USB port 12 connected to data line 14a and ground line 14b, respectively. Interconnect terminals 16a and 16b represent physical conductors, e.g., pins or leads, of CPU 16 that are connected to data line 14a and ground line 14b opposite USB port 12. Series protection circuit 30 is referred to as "series" because a signal on data line 14a, also referred to as a transmission line, flows through the series protection circuit serially between interconnect terminals 12a and 16a. TVS diode 20 is referred to as a "parallel" protection circuit because the parallel protection circuit is coupled between data line 14a and ground line 14b in parallel with CPU 16, or another load being protected. In other examples, parallel protection circuits other than TVS diodes are used.

Series protection circuit 30 operates similarly to a switch. FIG. 2a illustrates the switch of series protection circuit 30 closed, while FIG. 2b illustrates the switch open. During normal operation of mobile device 10, series protection circuit 30 is like the closed switch of FIG. 2a, allowing a signal on data line 14a to flow to interconnect terminal 16a and be received by CPU 16. TVS diode 20 is a substantially open circuit, and provides a relatively low capacitance to ground line 14b, helping to preserve signal integrity.

During an ESD event, TVS diode 20 has a significantly reduced electrical resistance to shunt ESD current to ground line 14b, clamping the voltage potential at interconnect terminal 16a to a safe level for CPU 16. TVS diode 20 can be a silicon avalanche pn-junction diode without snap-back, or a device with shallow or deep snap-back characteristics. TVS diode 20 may or may not include steering diodes to further reduce junction capacitance.

ESD events occur relatively quickly and last for a relatively short period, e.g., only a few nanoseconds. In many examples, series protection circuit 30 is not fast enough to guarantee sufficient protection of a load, thus the use of TVS diode 20 in combination with the series protection circuit helps protect from ESD events when series protection circuit 30 is insufficient.

During an EOS event, series protection circuit 30 activates and enters a high impedance state, approximating an open switch as shown in FIG. 2b. The load connected to interconnect terminal 16a, e.g., CPU 16, is effectively electrically isolated from the EOS source at interconnect terminal 12a. EOS events are generally of longer duration than ESD events, e.g., several microseconds, and TVS diode 20 may not be rated to handle the excess EOS current for the extended period. Thus, series protection circuit 30 helps avoid damage to TVS diode 20 during EOS events. Series protection circuit 30 is designed to withstand the maximum expected open circuit EOS voltage. The supplemental protection from series protection circuit 30 allows a TVS diode 20 to be used having a lower power handling capability, and thus lower size and lower capacitance to ground, than without the series protection circuit 30. Series protection circuit 30 reduces the maximum power absorbed by parallel protection circuit 20 by increasing resistance on data line 14a during EOS events.

FIG. 2c illustrates a parallel protection circuit 20 coupled to a ground node 34 rather than ground line 14b. In some embodiments, there is not necessarily a specific ground trace routed from a signal source to a signal destination. Parallel protection circuit 20 can be configured to dump excess energy from ESD events to any suitable ground node. Ground node 34 can be a ground plane within a PCB of mobile device 10, or any other ground reference circuit node of either mobile device 10 or the device coupled to USB port 12.

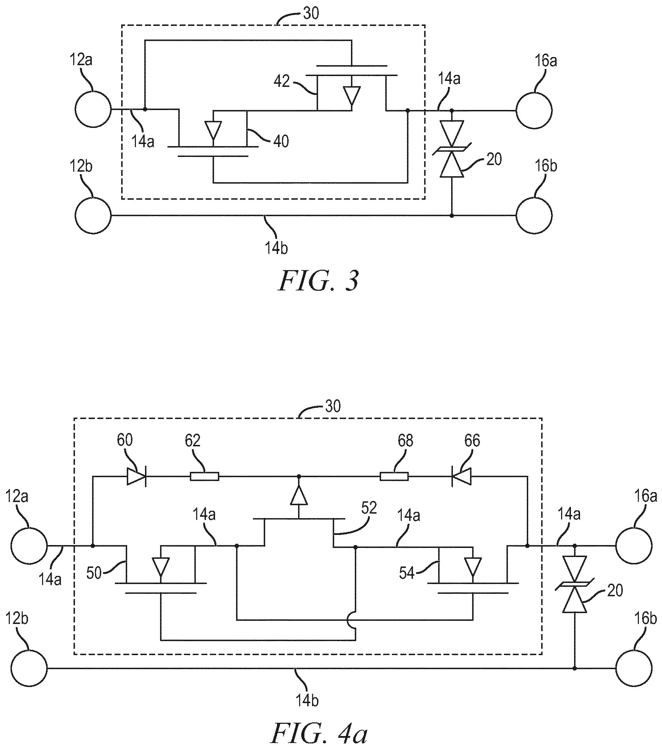

FIG. 3 illustrates one implementation of series protection circuit 30 that utilizes voltage blocking with field-effect transistors (FETs). Series protection circuit 30 is formed from N-channel depletion mode MOSFET (NMOS) 40 and P-channel depletion mode MOSFET (PMOS) 42. NMOS 40 includes a drain terminal coupled to interconnect terminal 12a at one end of data line 14a, and a gate terminal coupled to interconnect terminal 16a at the other end of the data line. PMOS 42 includes opposite connections, with a gate terminal coupled to interconnect terminal 12a at USB port 12 and a drain terminal coupled to interconnect terminal 16a. A source terminal of NMOS 40 is coupled to a source terminal of PMOS 42. TVS diode 20 remains coupled between interconnect terminal 16a and ground line 14b as a parallel protection circuit.

As electrical current from interconnect terminal 12a to the load at interconnect terminal 16a increases during an EOS event, the voltage potential drop across PMOS 42 increases, which turns off NMOS 40 by reducing the voltage at the gate terminal of the NMOS. Turning off NMOS 40 increases resistance through the NMOS, increasing the voltage potential from drain to source of PMOS 42, and regeneratively turning off the PMOS.

Other types of FETs besides strictly metal-oxide-semiconductor FETs are used in other embodiments. The underlying FET material may be silicon (Si), gallium nitride (GaN), or other semiconducting material. A GaN implementation has advantages of lower capacitance, decreased response time, increased drain-to-source voltage, and lower on-resistance per die area.

FIG. 4a illustrates a voltage blocking series protection circuit 30 with bidirectional protection. NMOS 50 includes a drain terminal coupled to interconnect terminal 12a. A source terminal of NMOS 50 is coupled to a first conduction terminal of JFET 52 and a gate terminal of NMOS 54. A gate terminal of NMOS 50 is coupled to a second conduction terminal of JFET 52 and a source terminal of NMOS 54. A drain terminal of NMOS 54 is coupled to interconnect terminal 16a. Steering diode 60 and resistor 62 are coupled in series between interconnect terminal 12a and a gate terminal of JFET 52. Steering diode 66 and resistor 68 are coupled in series between interconnect terminal 16a and the gate terminal of JFET 52. JFET 52 is a junction-gate field-effect transistor or a similar device. TVS diode 20 remains coupled between interconnect terminal 16a and ground line 14b as a parallel protection circuit.

Series protection circuit 30 in FIG. 4a substantially blocks EOS events at interconnect terminal 12a from reaching interconnect terminal 16a whether the EOS event is a positive or negative voltage potential. Series protection circuit 30 in FIG. 4a also substantially block EOS events at interconnect terminal 16a from reaching interconnect terminal 12a. If voltage at one of interconnect terminal 12a or interconnect terminal 16a becomes significantly higher than the other, electrical resistance through JFET 52 is increased by an increase in gate voltage. The resultant increased voltage drop across JFET 52 turns off NMOS 50 and 54.

Steering diodes 60 and 66 allow both interconnect terminal 12a and interconnect terminal 16a to be coupled to the gate of JFET 52 without creating a short-circuit circumventing series protection circuit 30. When interconnect terminal 16a has a higher voltage potential, diode 60 allows the higher voltage potential to propagate to the gate of JFET 52, but diode 66 blocks the higher voltage potential from propagating to interconnect terminal 16a. When interconnect terminal 12a has the lower voltage potential, diode 66 allows current to flow from interconnect terminal 16a to the gate of JFET 52, while diode 60 blocks the current from reaching interconnect terminal 12a. Steering diodes 60 and 66 and resistors 62 and 68 also help control the FET response time.

FIG. 4b illustrates the bidirectional voltage blocking circuit from FIG. 4a with JFET 52 replaced by a pair of MOSFETs 56-58. NMOS 50 and PMOS 56 operate as a pair to block EOS events at interconnect terminal 12a from reaching interconnect terminal 16a, similarly to NMOS 40 and PMOS 42 in FIG. 3. PMOS 58 and NMOS 54 operate as a pair to block EOS events at interconnect terminal 16a from reaching interconnect terminal 12a, or negative voltage EOS events at interconnect terminal 12a from reaching interconnect terminal 16a, again similarly to NMOS 40 and PMOS 42 from FIG. 3. PMOS 58 and NMOS 54 are in a mirrored configuration relative to NMOS 50 and PMOS 56. Diode 60, resistor 62, diode 66, and resistor 68 are optional because the two ends of series protection circuit 30 are not coupled to a gate of a common FET. However, the resistors and diodes 60-68 still help configure response time, and could be added to the series protection circuit in FIG. 3 as well.

FIG. 5 illustrates an embodiment of series protection circuit 30 that utilizes current blocking. A two-terminal series protection circuit 30 is represented by JFET 70 and resistor 72 coupled in series between interconnect terminal 12a and interconnect terminal 16a. A gate terminal of JFET 70 is coupled to interconnect terminal 16a on an opposite side of resistor 72 from the JFET. JFET 70 is a junction gate field-effect transistor or similar device. JFET 70 includes semiconductor material that forms a channel in either P-type or N-type silicon with ohmic connections at both ends. JFET 70 may include Si, GaN, or another appropriate semiconductor material. TVS diode 20 remains coupled between interconnect terminal 16a and ground line 14b as a parallel protection circuit.

For an n-channel JFET 70, P-type material is diffused alongside the N-type channel, forming a reversed biased pn-junction. The reversed biased pn-junction results in a depletion region near the channel. During an EOS event, the increased current through series protection circuit 30 increases the voltage potential gradient across resistor 72. The reduced gate voltage of JFET 70 increases the effective width of the depletion region, thus increasing resistance through the channel of the JFET. Once the channel is "pinched off", series protection circuit 30 holds the current approximately constant as voltage increases. A resistance value of resistor 72 can be modified to configure the amount of current through series protection circuit 30 required to begin shutting off JFET 70. During an EOS event, TVS diode 20 conducts residual electrical current let through series protection circuit 30 and continues to protect the load from ESD events. Once the surge of the EOS event subsides, series protection circuit 30 returns to a normal operating state.

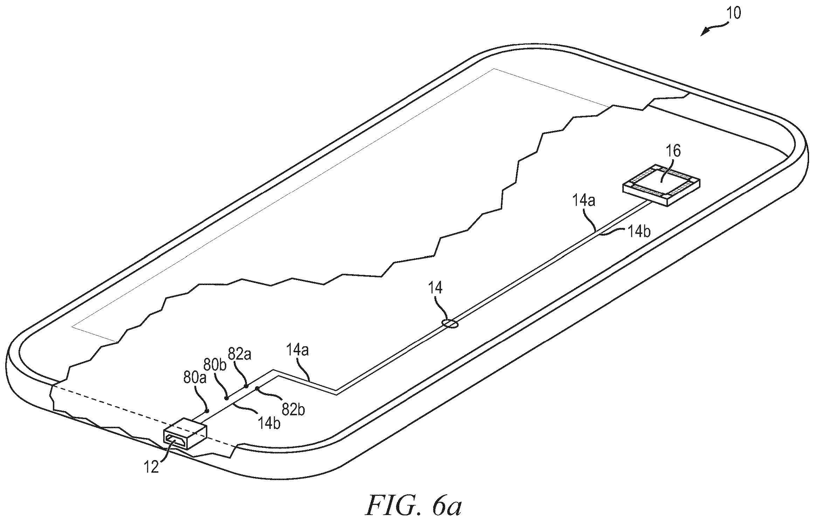

FIG. 6a illustrates mobile device 10 with conductive traces 14 configured for mounting of series protection circuit 30 and parallel protection circuit 20. Contact pads 80a and 80b are provided for mounting of series protection circuit 30, and contact pads 82a and 82b are provided for mounting of parallel protection circuit 20. Data line 14a is broken between contact pads 80a and 80b so that all electrical current along the data line is routed through series protection circuit 30.

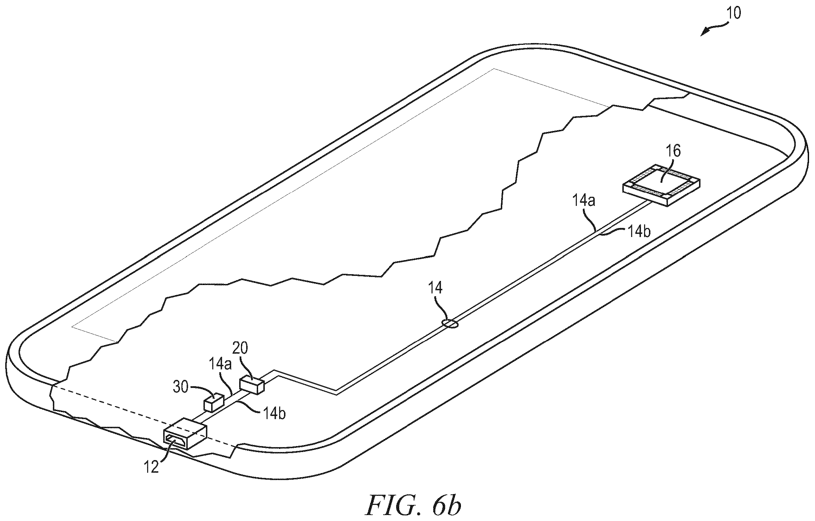

FIG. 6b illustrates series protection circuit 30 and parallel protection circuit 20 mounted onto the PCB of mobile device 10. Each of the protection circuits 20 and 30 are small two-terminal semiconductor packages. Solder bumps or other interconnect structures on the bottom of the protection circuits are reflowed onto contact pads 80 and 82 to mechanically attach and electrically connect the packages to conductive traces 14. Any suitable package type with any suitable interconnection method can be used for series protection circuit 30 and parallel protection circuit 20. Series protection circuit 30 creates an open circuit between USB port 12 and CPU 16 during EOS events with a long duration. The open circuit of series protection circuit 30 protects both CPU 16 and parallel protection circuit 20. During quicker ESD events, parallel protection circuit 20 becomes conductive to dump the excess charge to ground before series protection circuit 30 has time to react.

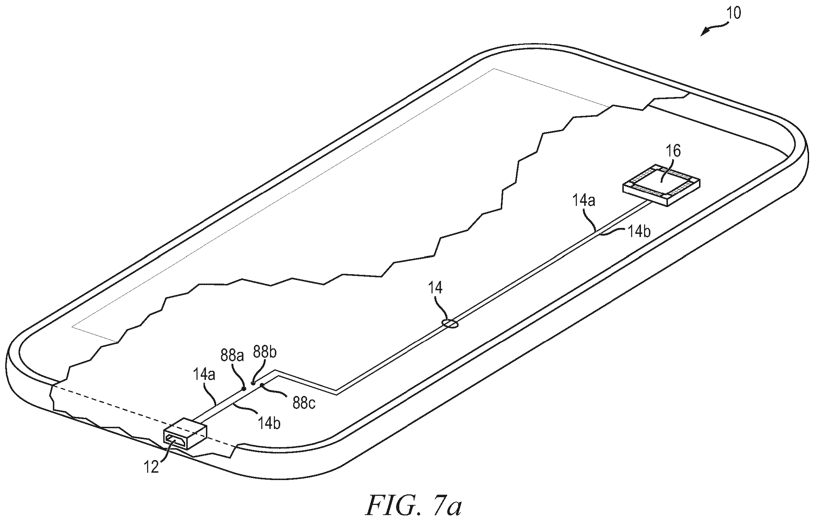

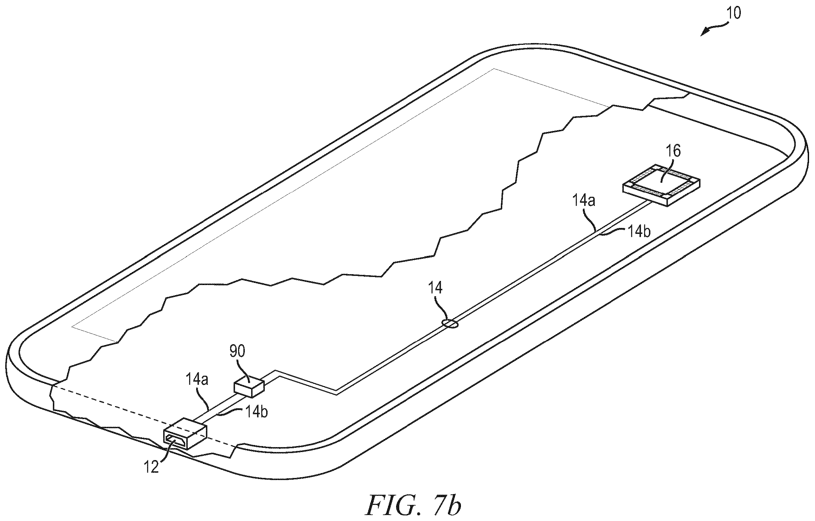

FIG. 7a illustrates mobile device 10 with conductive traces 14 configured for mounting of a monolithic package including both series protection circuit 30 and parallel protection circuit 20. The package is mounted onto contact pads 88a-88c. Internal to the package, series protection circuit 30 routes electrical current between contact pad 88a and contact pad 88b, while parallel protection circuit 20 is coupled between contact pads 88b and 88c. FIG. 7b illustrates monolithic package 90 mounted onto contact pads 88a-88c. Monolithic package 90 can include a single die with both parallel protection circuit 20 and series protection circuit 30 formed on the one die, or multiple dies can be combined in a multi-chip module.

In a monolithic implementation, device characteristics such as reaction time and current handling capability can be matched between parallel protection circuit 20 and series protection circuit 30. Matching the characteristics of parallel protection circuit 20 and series protection circuit 30 helps ensure that neither element is damaged when operated within rated EOS and ESD conditions. That is, monolithic package 90 can be configured to substantially ensure that series protection circuit 30 becomes an open circuit prior to parallel protection circuit 20 reaching the maximum amount of energy the parallel protection circuit can absorb. A monolithic implementation also allows interconnect inductance to be reduced, which reduces clamping voltage during ESD events with relatively fast rise times. The lower clamping voltage reduces the amount of energy absorbed during ESD events.

## Claims

1. A semiconductor device, comprising:
a first circuit node (12a) configured to be connected to a signal source;
a second circuit node (16a) configured to be connected to a load (16);
a resistor (72) directly coupled to the second circuit node, wherein the resistor includes a fixed resistance value;
a junction gate field-effect transistor, JFET, (70) including a first conduction terminal directly coupled to the first circuit node, wherein the JFET and the resistor are electrically coupled in series between the first circuit node and the second circuit node,
a first terminal of the resistor is coupled directly and exclusively to a second conduction terminal of the JFET and a second terminal of the resistor is coupled directly and exclusively to a gate terminal of the JFET and the second circuit node, in that the gate terminal of the JFET is electrically coupled directly to the second circuit node, and in that the resistance value of the resistor configures an amount of current through the semiconductor device required to begin shutting off the JFET; and
**characterized in that** the semiconductor device further comprises:
a parallel protection circuit comprising a transient-voltage-suppression, TVS, diode (20) electrically coupled between the second circuit node and a ground line (14b).

2. A method of making a semiconductor device, comprising:
providing a resistor (72) directly coupled to a load terminal (16a) of the semiconductor device, wherein the resistor includes a fixed resistance value;
providing a junction gate field-effect transistor, JFET, (70) including a first conduction terminal directly coupled to a signal source terminal (12a), wherein the JFET and the resistor are electrically coupled in series between the signal source terminal and the load terminal of the semiconductor device,
a first terminal of the resistor is coupled directly and exclusively to a second conduction terminal of the JFET and a second terminal of the resistor is coupled directly and exclusively to a gate terminal of the JFET and the load terminal, in that the gate terminal of the JFET is electrically coupled directly to the load terminal, and in that the resistance value of the resistor configures an amount of current through the semiconductor device required to begin shutting off the JFET; and
**characterized in that** the method further comprises:
providing a parallel protection circuit comprising a transient-voltage-suppression, TVS, diode (20) electrically coupled between the load terminal and a ground line (14b).

3. The method of claim 2, wherein a signal flows serially between the signal source (12a) and the load terminal (16a) through the JFET (70) and the resistor (72).

## Patentansprüche

1. Halbleitervorrichtung, umfassend:
einen ersten Schaltungsknoten (12a), ausgebildet zum Verbinden mit einer Signalquelle;
einen zweiten Schaltungsknoten (16a), ausgebildet zum Verbinden mit einer Last (16);
einen Widerstand (72), der direkt mit dem zweiten Schaltungsknoten gekoppelt ist, wobei der Widerstand einen festen Widerstandswert umfasst;
einen Junction-Gate-Feldeffekttransistor (JFET) (70), umfassend einen ersten Leitungsanschluss, der direkt mit dem ersten Schaltungsknoten gekoppelt ist, wobei der JFET und der Widerstand elektrisch in Reihe zwischen dem ersten Schaltungsknoten und dem zweiten Schaltungsknoten gekoppelt sind,
ein erster Anschluss des Widerstands direkt und ausschließlich mit einem zweiten Leitungsanschluss des JFET gekoppelt ist und ein zweiter Anschluss des Widerstands direkt und ausschließlich mit einem Gate-Anschluss des JFET und dem zweiten Schaltungsknoten gekoppelt ist, wobei der Gate-Anschluss des JFET elektrisch direkt mit dem zweiten Schaltungsknoten gekoppelt ist und wobei der Widerstandswert des Widerstands eine Strommenge durch die Halbleitervorrichtung bestimmt, die erforderlich ist, um das Abschalten des JFET einzuleiten; und
**dadurch gekennzeichnet, dass** die Halbleitervorrichtung ferner umfasst:
eine parallele Schutzschaltung, umfassend eine Transient-Voltage-Suppression-(TVS-)Diode (20), die elektrisch zwischen dem zweiten Schaltungsknoten und einer Masseleitung (14b) gekoppelt ist.

2. Verfahren zum Herstellen einer Halbleitervorrichtung, umfassend:
Bereitstellen eines Widerstands (72), der direkt mit einem Lastanschluss (16a) der Halbleitervorrichtung gekoppelt ist, wobei der Widerstand einen festen Widerstandswert umfasst;
Bereitstellen eines Junction-Gate-Feldeffekttransistor (JFET) (70), umfassend einen ersten Leitungsanschluss, der direkt mit einem Signalquellenanschluss (12a) gekoppelt ist, wobei der JFET und der Widerstand elektrisch in Reihe zwischen dem Signalquellenanschluss und dem Lastanschluss der Halbleitervorrichtung gekoppelt sind,
ein erster Anschluss des Widerstands direkt und ausschließlich mit einem zweiten Leitungsanschluss des JFET gekoppelt ist und ein zweiter Anschluss des Widerstands direkt und ausschließlich mit einem Gate-Anschluss des JFET und dem zweiten Lastanschluss gekoppelt ist, wobei der Gate-Anschluss des JFET elektrisch direkt mit dem Lastanschluss gekoppelt ist und wobei der Widerstandswert des Widerstands eine Strommenge durch die Halbleitervorrichtung bestimmt, die erforderlich ist, um das Abschalten des JFET einzuleiten; und
**dadurch gekennzeichnet, dass** das Verfahren ferner umfasst:
Bereitstellen einer parallelen Schutzschaltung, umfassend eine Transient-Voltage-Suppression-(TVS-)Diode (20), die elektrisch zwischen dem Lastanschluss und einer Masseleitung (14b) gekoppelt ist.

3. Verfahren nach Anspruch 2, wobei ein Signal in Reihe zwischen der Signalquelle (12a) und dem Lastanschluss (16a) durch den JFET (70) und den Widerstand (72) fließt.

## Revendications

1. Dispositif à semi-conducteur, comprenant :
un premier nœud de circuit (12a) configuré pour être connecté à une source de signal ;
un second nœud de circuit (16a) configuré pour être connecté à une charge (16) ;
une résistance (72) couplée directement au second nœud de circuit, dans lequel la résistance comporte une valeur de résistance fixe ;
un transistor à effet de champ à grille et jonction, JFET, (70) comportant une première borne de conduction couplée directement au premier nœud de circuit, dans lequel le JFET et la résistance sont couplés électriquement en série entre le premier nœud de circuit et le second nœud de circuit,
une première borne de la résistance est couplée directement et exclusivement à une seconde borne de conduction du JFET et une seconde borne de la résistance est couplée directement et exclusivement à une borne de grille du JFET et au second nœud de circuit, la borne de grille du JFET est couplée électriquement directement au second nœud de circuit, et la valeur de résistance de la résistance configure une quantité de courant à travers le dispositif à semi-conducteur nécessaire pour commencer à bloquer le JFET ; et
**caractérisé en ce que** le dispositif à semi-conducteur comprend en outre :
un circuit de protection en parallèle comprenant une diode de suppression de tension transitoire, TVS, (20) couplée électriquement entre le second nœud de circuit et une ligne de masse (14b).

2. Procédé de fabrication d'un dispositif à semi-conducteur, comprenant :
la fourniture d'une résistance (72) couplée directement à une borne de charge (16a) du dispositif à semi-conducteur, dans lequel la résistance comporte une valeur de résistance fixe ;
la fourniture d'un transistor à effet de champ à grille et jonction, JFET, (70) comportant une première borne de conduction couplée directement à une borne de source de signal (12a), dans lequel le JFET et la résistance sont couplés électriquement en série entre la borne de source de signal et la borne de charge du dispositif à semi-conducteur,
une première borne de la résistance est couplée directement et exclusivement à une seconde borne de conduction du JFET et une seconde borne de la résistance est couplée directement et exclusivement à une borne de grille du JFET et à la borne de charge, la borne de grille du JFET est couplée électriquement directement à la borne de charge, et la valeur de résistance de la résistance configure une quantité de courant à travers le dispositif à semi-conducteur nécessaire pour commencer à bloquer le JFET ; et
**caractérisé en ce que** le procédé comprend en outre :
la fourniture d'un circuit de protection en parallèle comprenant une diode de suppression de tension transitoire, TVS, (20) couplée électriquement entre la borne de charge et une ligne de masse (14b).

3. Procédé selon la revendication 2, dans lequel un signal circule en série entre la source de signal (12a) et la borne de charge (16a) à travers le JFET (70) et la résistance (72).
